# DEMANDE DE BREVET EUROPEEN

(11) **EP 1 217 725 A1**
(43) Date de publication de la demande: **26.06.2002**
(21) Numéro de dépôt: 01403225.4
(22) Date de dépôt: 12.12.2001
(51) Int. Cl.: H03F 3/60

(54) **Diode de décalage en tension réalisée en technologie intégré monolithique hyperfréquence, notamment pour émetteur optoélectronique hyperfréquence à très large bande**

(30) Priorité: 22.12.2000 FR 0016937
(71) Demandeur: Thales, 75008 Paris (FR)
(72) Inventeur: Dueme, Philippe, 91400 Orsay (FR); Decaesteke, Thierry, 78490 Montfort L'Amaury (FR)
(74) Mandataire: Plaçais, Jean-Yves

(57) **Abrégé**

Le dispositif d'interface comprend une diode (DD) de décalage en tension réalisée en technologie intégrée monolithique hyperfréquence, montée entre la sortie (S) du circuit amont (16) et l'entrée du circuit aval (18). La caractéristique de la diode de décalage (DD) est choisie de telle sorte que la tension de polarisation (VD) du circuit amont (16) soit décalée d'un décalage correspondant sensiblement à l'écart entre les tensions de polarisation (VD et VL) des circuits amont (16) et aval (8). Le courant de polarisation du circuit aval est relativement élevé par rapport au courant de seuil de la diode de décalage.

## Description

La présente invention concerne une diode de décalage en tension réalisée en technologie intégrée monolithique hyperfréquence. Ladite diode de décalage est destinée à assurer un décalage en tension entre deux circuits dont le circuit aval consomme un courant de polarisation relativement élevé. Par exemple, le circuit aval est un émetteur optoélectronique hyperfréquence à très large bande, allant de quelques Hz à plusieurs GHz, telle qu'une diode laser.

Elle trouve une application générale dans la fabrication de circuits intégrés monolithiques hyperfréquences, appelés encore MMIC pour "Monolithic Microwave Integrated Circuit", et plus particulièrement en optoélectronique, dans la transmission de signaux hyperfréquences sur fibres optiques.

On connaît déjà des émetteurs optoélectroniques du type diode laser émettant des signaux hyperfréquence à très large bande.

Par exemple, dans le brevet FR 96 04 524, un amplificateur distribué dit transimpédance joue le rôle d'amplificateur et d'adaptateur basse impédance pour une diode laser émettant des signaux hyperfréquence à très large bande.

D'une manière générale, un amplificateur distribué (simple ou transimpédance) comporte une pluralité de cellules amplificatrices de base, montées entre une ligne d'entrée et une ligne de sortie. Chaque cellule amplificatrice de base comporte au moins un transistor à effet de champ, bipolaire, ou analogue. Par exemple, dans le cas de transistors à effet de champ montés en source commune, chaque transistor est relié à la ligne de drains commune (ligne de sortie) par son drain ainsi qu'à la ligne de grille commune (ligne d'entrée) par sa grille. Par la suite, on limitera la description à des transistors à effet de champ, mais l'homme du métier sait qu'il pourra transposer sans difficultés la présente invention à des transistors bipolaires ou analogues.

Le fonctionnement correct d'un transistor à effet de champ nécessite l'application d'une tension de polarisation continue sur son drain, et l'application d'une tension de polarisation continue sur sa grille.

En pratique, les circuits de filtrage de polarisation doivent laisser passer les tensions ou courants continus de polarisation et isoler la puissance hyperfréquence. A cet effet, (notamment dans le brevet FR 96 04 524), la borne d'alimentation qui reçoit la tension de polarisation des drains des transistors est reliée à la ligne de drains commune à travers une résistance de polarisation et une capacité de découplage en parallèle reliée à la masse. De son côté, la borne d'alimentation qui reçoit la tension de polarisation des grilles des transistors est reliée à la ligne de grille commune à travers une résistance de polarisation et une capacité de découplage en parallèle reliée à la masse.

De plus, (comme dans le brevet FR mentionné ci-avant), une capacité de liaison est prévue entre la ligne de drains commune, qui forme la sortie de l'amplificateur distribué, et l'anode de la diode laser.

Une telle capacité de liaison isole la puissance hyperfréquence de la polarisation continue.

Mais une telle capacité de liaison empêche aussi le passage des basses fréquences, par exemple celles inférieures à 500 MHz, que demandent certaines applications de transmission de signaux hyperfréquences.

La solution consistant à compléter la capacité de liaison par une capacité de forte valeur montée à l'extérieur du circuit ne peut pas être envisagée ici pour augmenter l'impédance de la capacité de liaison. En effet, contrairement à une capacité de découplage dont l'une des armatures est reliée à la masse, une capacité de liaison est placée entre deux points de tension non nulle, ce qui empêche le montage d'une capacité extérieure au circuit intégré (puce MMIC).

La présente invention apporte une solution à ce problème.

Elle porte sur un dispositif d'interface entre deux circuits, dont le circuit amont comprend une sortie et des moyens de polarisation en tension continue, et dont le circuit aval comprend une entrée, utilise une tension continue de polarisation de valeur plus élevée que celle du circuit amont et consomme un courant de polarisation relativement important qui est fonction de la puissance délivrée par le circuit aval.

Selon une définition générale de l'invention, le dispositif d'interface comprend une diode de décalage en tension montée entre la sortie du circuit amont et l'entrée du circuit aval, la caractéristique de la diode de décalage étant choisie de telle sorte que la tension de polarisation du circuit amont soit décalée d'un décalage correspondant sensiblement à l'écart entre les tensions de polarisation des circuits amont et aval et dont la valeur correspond sensiblement à la tension de seuil de la diode de décalage, et le courant de polarisation du circuit aval étant relativement important par rapport au courant de seuil de la diode de décalage.

Une telle diode de décalage permet de supprimer la capacité de liaison entre les circuits amont et aval, ce qui rend ledit circuit aval apte à fonctionner dans une très large bande de fréquence allant de quelques Hz à plusieurs GHz.

Même si on connaît déjà des diodes réalisées en technologie intégrée monolithique hyperfréquence (Demande de brevet FR-A-2661790), l'homme du métier n'est en aucune manière guidé pour les utiliser afin de supprimer une capacité de liaison tout en laissant passer un courant de polarisation relativement élevé, qui est fonction de la puissance délivrée par le circuit aval.

Il est à noter que dans la Demande FR-A-2661790, le pont à diodes est utilisé dans une boucle de contre réaction dans laquelle passe un courant relativement faible, sensiblement égal au courant de seuil des diodes élémentaires du pont à diodes.

En pratique, la diode de décalage comprend une pluralité de transistors réalisés en technologie intégrée monolithique hyperfréquence et montés en parallèle entre la sortie du circuit amont et l'entrée du circuit aval.

Selon un mode préféré de réalisation de l'invention, chaque transistor de la diode de décalage comprend un drain et une source reliés l'un à l'autre, chaque doigt de grille formant un contact à effet diode.

Selon une caractéristique importante de l'invention, le circuit aval comprend une diode laser capable d'émettre des signaux hyperfréquences à très large bande.

De son côté, le circuit amont comprend un circuit de commande de la diode laser d'impédance 50 ohms et un amplificateur de puissance distribué jouant le rôle d'adaptateur basse impédance.

D'autres caractéristiques et avantages de l'invention apparaîtront à la lumière de la description détaillée ci-après et des dessins dans lesquels :
- la figure 1 est un schéma d'une liaison de télécommunication en hyperfréquence sur fibre optique entre une diode laser et une photodiode selon l'art antérieur ;
- la figure 2 est un schéma d'un amplificateur distribué de l'art antérieur relié à l'entrée de la diode laser décrite en référence à la figure 1 ;
- la figure 3 est une représentation schématique de l'amplificateur distribué de la figure 2, relié à l'entré de la diode laser à travers une diode de décalage en tension selon l'invention ;
- la figure 4 est un graphique qui illustre la caractéristique de la diode de décalage en tension selon l'invention ;
- la figure 5 est une variante de réalisation selon l'invention de l'amplificateur distribué de la figure 3, dans lequel le circuit de polarisation de la ligne de drains commune utilise des transistors supplémentaires fonctionnant en charge saturable ;
- les figures 6A et 6B représentent schématiquement des modes de réalisation des doigts de grille des transistors de la diode de décalage selon l'invention ; et
- la figure 7 représente schématiquement un masque d'un circuit réalisé en technologie MMIC contenant l'amplificateur distribué et la diode de décalage selon l'invention.

Les dessins comportent des éléments de caractère certain. A ce titre, ils peuvent non seulement servir à mieux faire comprendre l'invention mais aussi à contribuer à la définition de celle-ci le cas échéant.

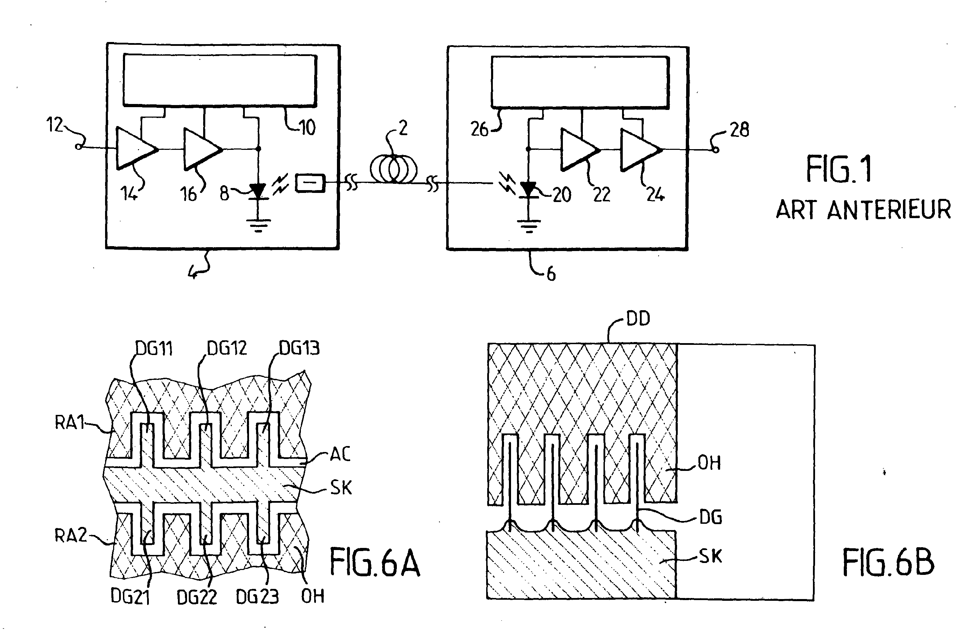

En référence à la figure 1, on a représenté une liaison de télécommunication en hyperfréquence très haut débit sur fibre optique 2 entre une tête émettrice 4 et une tête réceptrice 6. La liaison utilise une modulation d'amplitude directe. La tête émettrice 4 comprend une diode laser 8 dont le courant est modulé par le signal radiofréquence et hyperfréquence incident 12. La tête émettrice 4 comprend un dispositif de polarisation 10, le cas échéant un étage de pré-amplification 14, et un étage d'amplification et d'adaptation d'impédance 16. L'étage 16 a pour rôle d'effectuer une adaptation entre la faible impédance de la diode laser (de l'ordre de 10 ohms) et l'impédance classique (50 ohms) du dispositif d'entrée (commande) de la diode laser.

Côté tête réceptrice 6, une photodiode 20 capte les signaux transmis par la fibre optique 2. La tête réceptrice 6 comprend également un étage d'adaptation d'impédance 22, le cas échéant un étage de pré-amplification 24, et un dispositif de polarisation de la photodiode 26. La sortie 28 de la tête réceptrice peut délivrer un signal hyperfréquence à très large bande allant de quelques Hz à plusieurs GHz.

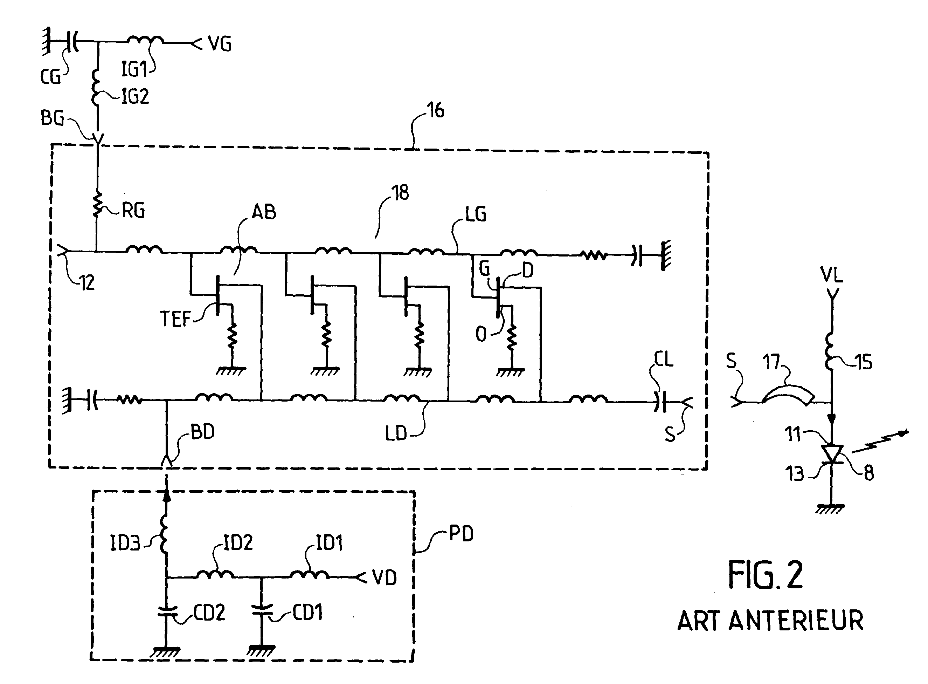

En référence à la figure 2, l'étage 16 comprend un amplificateur distribué 18 dit transimpédance jouant le rôle d'amplificateur et d'adaptateur basse impédance pour la diode laser 8.

De manière connue, l'amplificateur distribué 18 comporte une pluralité de cellules amplificatrices de base AB, montées entre une ligne d'entrée (ligne de drains commune LD dans le cas de transistors à effet de champ montés en source commune) et une ligne de sortie (ligne de grille commune LG). Chaque cellule amplificatrice de base AB comporte au moins un transistor TEF à effet de champ monté en source O commune et relié à la ligne de drains commune LD par son drain D ainsi qu'à la ligne de grille commune LG par sa grille G.

Le fonctionnement correct d'un transistor à effet de champ TEF nécessite l'application d'une tension de polarisation VD continue sur son drain D, et l'application d'une tension de polarisation continue VG sur sa grille G.

Par exemple, la borne d'alimentation BG qui reçoit la tension de polarisation VG des grilles des transistors est reliée à la ligne de grille commune LG à travers une résistance RG (de l'ordre de 1 Kiloohms par exemple) et une capacité de découplage CG en parallèle reliée à la masse. Des fils d'inductance IG1 et IG2 relient l'alimentation délivrant la tension VG à la borne BG.

Par exemple, la ligne de drains commune LD est polarisée en tension VD via un circuit de filtrage d'alimentation PD relié à la borne d'alimentation BD à travers des inductances ID1, ID2 et ID3 et des capacités de découplage CD1 et CD2 en parallèle et reliées à la masse.

La sortie S de l'amplificateur distribué 18 est reliée à l'anode 11 de la diode laser 8 à travers un ruban ou fil 17. La cathode 13 de la diode laser 8 est reliée à la masse. La diode laser 8 est polarisée selon une tension de polarisation continue VL à travers une inductance 15, par exemple de l'ordre de 15nH.

Par exemple, le courant de la diode laser 8 est de l'ordre de 150 mA et la tension de la diode laser 8 est de l'ordre de 1,4 volts.

Une capacité de liaison CL est prévue selon l'art antérieur entre l'extrémité de la ligne de drains commune LD qui forme la sortie S de l'amplificateur distribué et l'anode 11 de la diode laser 8 (via le ruban 17).

Comme vu ci-avant, une telle capacité de liaison CL isole la puissance hyperfréquence de la polarisation continue. Mais une telle capacité de liaison CL empêche aussi le passage des basses fréquences.

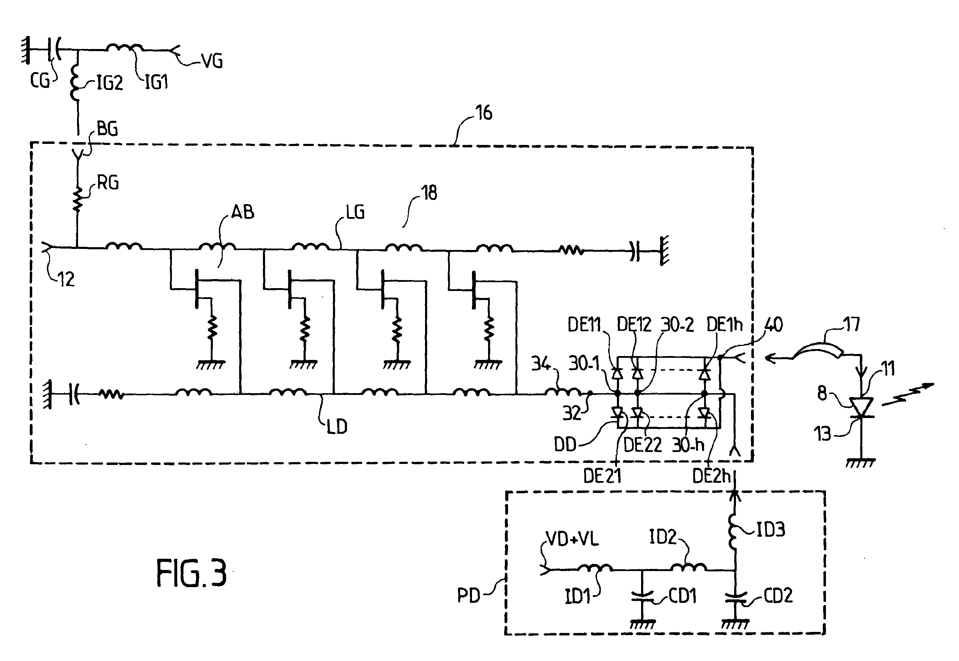

En référence à la figure 3, on a représenté l'amplificateur distribué 18 décrit en référence à la figure 2 dans lequel on a notamment remplacé la capacité de liaison CL par une diode de décalage DD selon l'invention.

La diode de décalage DD en tension est montée entre l'extrémité 32 d'une inductance 34 formant la sortie S de l'amplificateur distribué 18 et l'anode 11 de la diode laser 8 à travers le fil ou ruban 17.

En pratique, la diode de décalage comprend une pluralité de transistors réalisés en technologie monolithique hyperfréquence large bande et montés en parallèle entre la sortie du circuit amont et l'entrée du circuit aval.

De préférence, chaque transistor de la diode de décalage comprend un drain et une source reliés l'un à l'autre, ce qui forme une diode élémentaire DE.

En référence à la figure 3, la diode de décalage DD comprend par exemple deux rangées RA1 et RA2 de diodes élémentaires DE montées en parallèles entre la sortie de l'amplificateur distribué et la diode laser.

La première rangée RA1 de diodes élémentaires DE comprend n diodes individualisées en DE11 à DE1n, avec par exemple n égal à 74 et la seconde rangée RA2 de diodes élémentaires comprend n diodes individualisées en DE21 à DE2n, avec par exemple n égal à 74.

Par exemple, les diodes élémentaires sont agencées selon un arrangement dans lequel le noeud 30-1 est relié en série à la sortie (ici l'extrémité de l'inductance 34) de l'amplificateur distribué, et en parallèle à l'anode de la diode DE11 et à l'anode de la diode DE21. De son côté, le noeud 30-2 est relié en série au noeud 30-1, et en parallèle à l'anode de la diode DE12 et à l'anode de la diode DE22. De même, le noeud 30-n est relié en série au noeud 30-n-1, et en parallèle à l'anode de la diode DE1n et à l'anode de la diode DE2n.

Les cathodes des diodes élémentaires DE sont reliées au noeud 40 destiné à être relié à l'anode de la diode laser 8, via le ruban 17 (le cas échéant).

Le noeud 30-n peut jouer avantageusement la borne d'alimentation qui reçoit la tension de polarisation VD de la ligne de drains commune LD à travers le circuit de filtrage PD décrit en référence à la figure 2.

Selon l'invention, le circuit de filtrage PD peut aussi jouer le rôle de filtrage de la tension de polarisation VL de la diode laser 8, ce qui permet de supprimer l'inductance 15 décrite en référence à la figure 2.

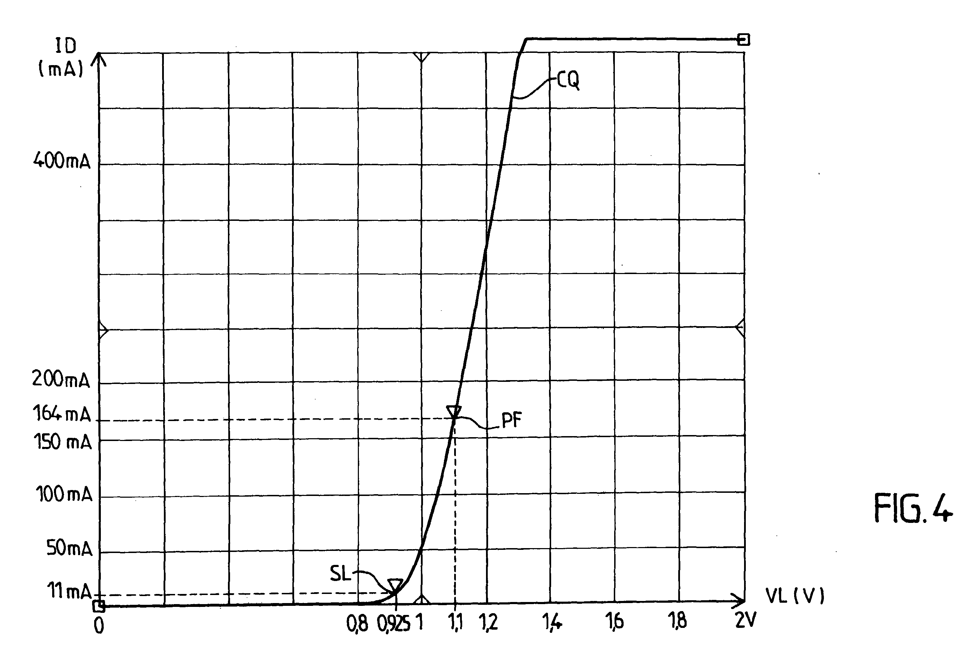

En référence à la figure 4, on a représenté la caractéristique CQ de la diode de décalage DD qui donne la tension continue VL (en volt) aux bornes de la diode de décalage DD en fonction de l'intensité ID (en ampère) qui la traverse.

La diode de décalage DD est choisie de telle sorte que la tension de polarisation VD de la ligne de drains commune LD soit décalée d'un décalage correspondant sensiblement à l'écart entre la tension de polarisation VD de la ligne de drains commune LD et la tension de polarisation VL de la diode laser.

En pratique, le point de fonctionnement PF de la diode de décalage est choisi égal à 1,1 V avec une intensité maximale d'utilisation de 164 mA et le seuil SL de la diode de décalage est choisi égal à 0,925 V avec une intensité minimale de 11 mA. Le courant de seuil (ici 11 mA) de la diode de décalage est donc relativement faible par rapport au courant que consomme le circuit aval (ici 164 mA).

Avec une tension de polarisation de la diode laser VL de l'ordre de 1,4 Volts et une tension de polarisation de la ligne de drains commune VD de l'ordre de 2,5 Volts, le décalage en tension est ainsi de l'ordre de 1,1 V, ce qui correspond sensiblement à la valeur du point de fonctionnement PF de la diode de décalage DD.

En raison de la suppression de la capacité de liaison CL entre les circuits amont 16 et aval 8 et son remplacement par la diode de décalage DD, la diode laser 8 peut fonctionner dans une très large bande de fréquence allant par exemple de quelques Hz à plusieurs GHz.

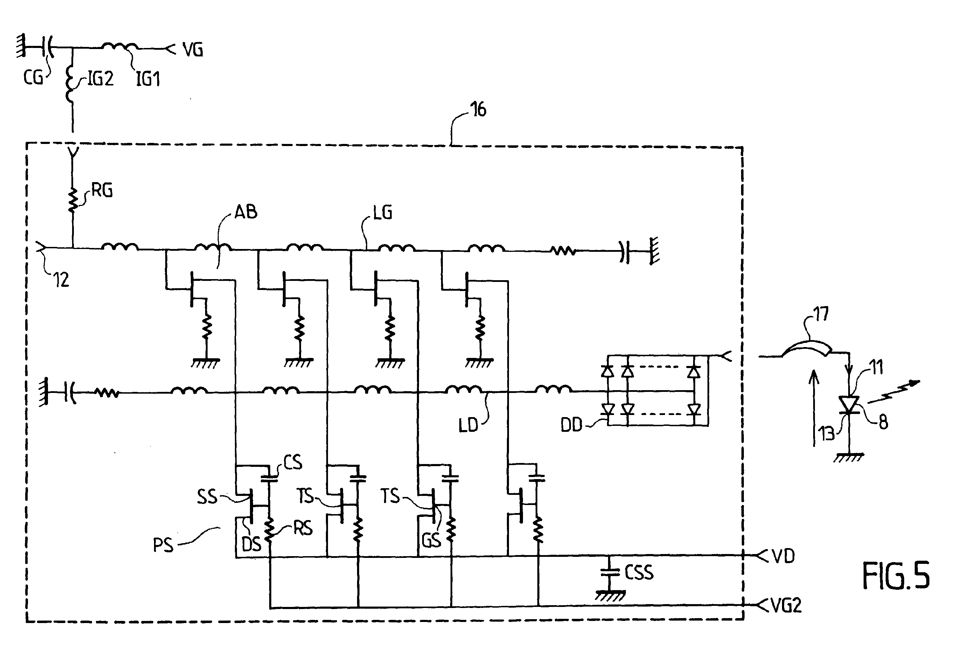

En référence à la figure 5, on a remplacé le circuit de filtrage d'alimentation PD en tension VD de la ligne de drains commune décrite en référence aux figures 2 et 3 par un circuit de filtrage de polarisation PS utilisant des transistors supplémentaires TS fonctionnant en charge saturable.

En pratique, le circuit PS comprend une pluralité de transistors supplémentaires TS fonctionnant en charge saturable. Les sources SS des transistors supplémentaires TS sont distributivement connectées sur la ligne de drains commune LD.

Les drains DS des transistors supplémentaires TS reçoivent en série la tension de polarisation VD.

Les grilles GS des transistors supplémentaires reçoivent en série une seconde tension de polarisation de grille VG2, le cas échéant respectivement à travers une résistance supplémentaire RS. En pratique,la tension VG2 est reliée à la masse en parallèle à travers une capacité dé découplage CSS. De plus, chaque grille supplémentaire est reliée à sa source respective à travers une capacité supplémentaire CS.

Le circuit PS remédie aux inconvénients (déperdition d'énergie, encombrement) résultant du filtrage des circuits de polarisation à travers des résistances terminales RG comme celle décrite en référence à la figure 2.

De même, le circuit PS remédie aux inconvénients (dégradations des performances, désadaptation d'impédance, résonance, encombrement, soudures) résultant du filtrage des circuits de polarisation à travers des éléments selfiques 15, ID1, ID2, ID3 comme ceux décrits en référence aux figures 2 et/ou 3.

En référence à la figure 6A, on a représenté un mode de réalisation de la diode de décalage qui comprend une pluralité de transistors à effet de champ réalisés en technologie intégrée monolithique hyperfréquence.

La diode de décalage DD comprend par exemple deux rangées RA1 et RA2 de n transistors. Chaque transistor forme une diode élémentaire DE en reliant son drain à sa source.

Chaque transistor comprend un doigt de grille DG, individualisé en DG11 à DG1n pour la première rangée RA1 et en DG21 à DG2n pour la seconde rangée RA2.

Par exemple, le courant de chaque doigt de grille DG est inférieur à 1 milliampère (pour n = 148) et le courant de polarisation VD de la ligne de drain LD est de l'ordre de 150 à 300 milliampères.

Chaque doigt de grille DG de la diode DD est réalisé selon un contact dit "Schottky" SK similaire aux grilles des transistors à effet de champ. En pratique, un contact "Schottky" SK est un contact métal/semi-conducteur qui résulte en une barrière de potentiel AC. Un tel contact "Schottky" présente un effet diode.

En revanche, les drains et les sources des transistors de la diode de décalage sont réalisés selon un contact dit "ohmique" OH qui est un contact métal/semi conducteur nécessitant une métallurgie plus complexe que celle du contact Schottky SK. Un tel contact ohmique implique généralement des matériaux du type Germanium, Or, ou Arséniure de Gallium, et résulte en l'absence de barrière de potentiel. C'est donc un contact sans effet diode avec une résistance de faible valeur.

La zone intermédiaire AC entre le contact ohmique et le contact Schottky est une zone active.

Chaque doigt de grille a un développement individuel de l'ordre de 5 micromètres. Ainsi, la diode de décalage a un développement de grille total de l'ordre de 148 x 5 micromètres, soit de l'ordre de 740 micromètres.

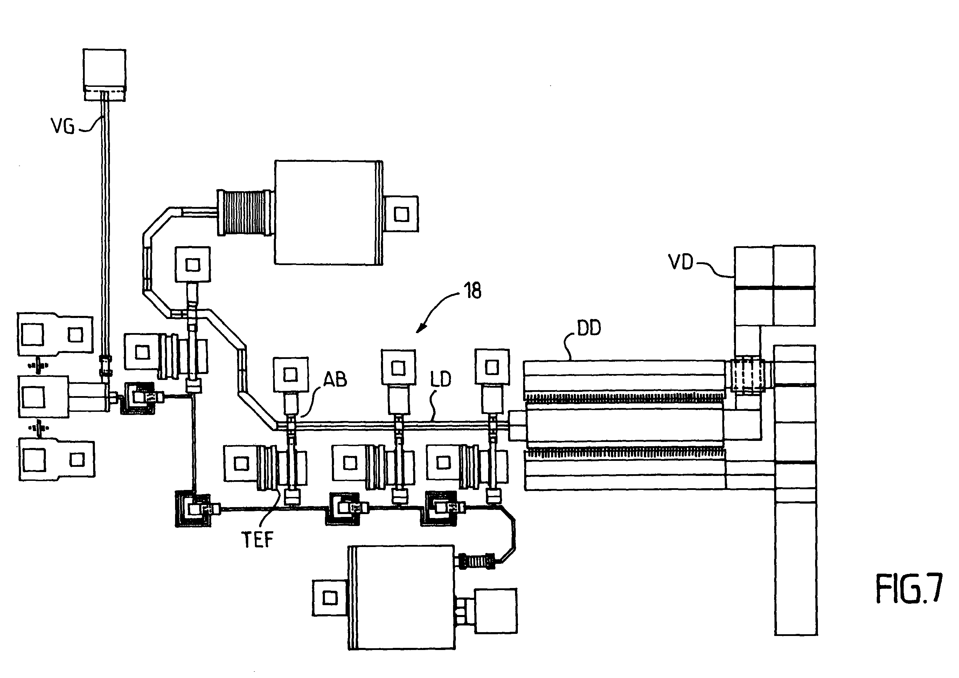

En référence à la figure 7, on a représenté un masque qui illustre la réalisation du circuit 16 décrit en référence à la figure 3 et qui comprend un amplificateur distribué 18 selon l'invention et une diode de décalage DD.

En référence à la figure 6B, on a représenté une portion agrandie du masque de la diode de décalage dans laquelle on distingue parfaitement les doigts de grille DG.

## Revendications

1. Dispositif d'interface entre deux circuits dont le circuit amont comprend une sortie et des moyens de polarisation en tension continue et dont ledit circuit aval comprend une entrée, requière une tension continue de polarisation de valeur plus élevée que celle du circuit amont, et consomme un courant de polarisation relativement important qui est fonction de la puissance délivrée par le circuit aval,
**caractérisé en ce qu'**il comprend une diode (DD) de décalage en tension réalisée en technologie intégrée monolithique hyperfréquence, montée entre la sortie (S) du circuit amont (16) et l'entrée du circuit aval (18), la caractéristique de la diode de décalage (DD) étant choisie de telle sorte que la tension de polarisation (VD) du circuit amont (16) soit décalée d'un décalage correspondant sensiblement à l'écart entre les tensions de polarisation (VD et VL) des circuits amont (16) et aval (8), et **en ce que** le courant de polarisation du circuit aval étant relativement élevé par rapport au courant de seuil de la diode de décalage.

2. Dispositif selon la revendication 1, **caractérisé en ce que** la diode de décalage (DD) comprend une pluralité de transistors montés en parallèle entre la sortie du circuit amont et l'entrée du circuit aval.

3. Dispositif selon la revendication 2, **caractérisé en ce que** chaque transistor de la diode de décalage comprend un drain et une source reliés l'un à l'autre, le doigt de grille de chaque transistor formant un contact avec effet diode.

4. Dispositif selon l'une des revendications 1 à 3, **caractérisé en ce que** le circuit aval (8) comprend une diode laser capable d'émettre des signaux hyperfréquences à très large bande.

5. Dispositif selon la revendication 4, **caractérisé en ce que** le circuit amont comprend un circuit de commande (10, 12, 14) de la diode laser dont l'impédance est de 50 ohms.

6. Dispositif selon la revendication 4, **caractérisé en ce que** le circuit aval (8) est de basse impédance de l'ordre de quelques ohms.

7. Dispositif selon les revendication 5 et 6, **caractérisé en ce que** le circuit amont comprend en outre un amplificateur distribué (16) adaptateur basse impédance.

8. Dispositif selon la revendication 7, **caractérisé en ce que** l'amplificateur distribué (16) comprend une pluralité de cellules amplificatrices (AB) montées entre une ligne d'entrée (LG) et une ligne de sortie (LD), l'une des extrémités de la ligne d'entrée, formant l'entrée de l'amplificateur distribué et étant reliée au circuit de commande de la diode laser, l'une des extrémités de la ligne de sortie (LD) formant la sortie (S) de l'amplificateur distribué, et les moyens de polarisation du circuit amont appliquant une tension de polarisation (VD) à la ligne de sortie (LD).

9. Dispositif selon la revendication 1, **caractérisé en ce que** le courant de polarisation du circuit aval est de l'ordre de plusieurs dizaines de mA.

10. Dispositif selon la revendication 3 et la revendication 9, **caractérisé en ce que** le développement individuel de chaque doigt de grille est de l'ordre de quelques micromètres et **en ce que** le développement total de la diode de décalage est de l'ordre de plusieurs dizaines de micromètres.

11. Dispositif selon l'une des revendications précédentes, **caractérisé en ce qu'**il comprend en outre un circuit de filtrage de polarisation de la ligne de sortie (LD) comportant un dispositif (PS) à transistors fonctionnant à charge saturable.
